# EUROPÄISCHE PATENTSCHRIFT

(11) **EP 2 770 314 B1**
(45) Veröffentlichungstag und Bekanntmachung des Hinweises auf die Patenterteilung: **25.07.2018**
(21) Anmeldenummer: 14156441.9
(22) Anmeldetag: 24.02.2014
(51) Int. Cl.: G01L 1/14, G06F 3/044, H03K 17/96

(54) **Zweikanaliger, mehrlagiger taktiler Sensor**
Dual channel, multilayer tactile sensor
Capteur tactile à plusieurs couches et à deux canaux

(30) Priorität: 25.02.2013 DE 102013101835
(43) Veröffentlichungstag der Anmeldung: 27.08.2014
(73) Patentinhaber: Haake Technik GmbH, 48691 Vreden (DE)
(72) Erfinder: Schoppen, Jens, 48703 Stadtlohn (DE)
(74) Vertreter: Habbel, Ludwig

(56) Entgegenhaltungen:
- EP-A2- 0 684 579
- DE-C- 633 460
- US-A1- 2002 190 727

## Beschreibung

Die Erfindung betrifft einen zweikanaligen, mehrlagigen taktilen Sensor.

Derartige Sensoren sind aus der Praxis beispielsweise als so genannte Schaltmatten bekannt. Nachfolgend wird aus Gründen der Vereinfachung vielfach eine Schaltmatte erwähnt, die jedoch lediglich als Beispiel dient und stellvertretend für taktile Sensoren steht.

Die bekannten Schaltmatten stellen eine Weiterentwicklung dar zu dem Grundprinzip einer Schaltmatte, bei welchem zwei Elektroden-Lagen durch eine drucksensitive Zwischenschicht voneinander getrennt sind. Die Zwischenschicht kann beispielsweise komprimierbare Elemente aufweisen, so dass bei einem Druck, der quer zur Fläche der Schaltmatte gerichtet ist, die beiden Elektroden der beiden äußeren Lagen aufeinander gedrückt werden und zwischen diesen komprimierbaren Elementen unmittelbar in Kontakt zueinander kommen können.

Alternativ ist es bekannt, für die Zwischenschicht ein Material zu verwenden, welches unter Druck seinen elektrischen Widerstand ändert. Diese Zwischenschicht kann vollflächig ausgestaltet sein, so dass auch dann, wenn die beiden Elektroden nicht in unmittelbaren Kontakt miteinander geraten mittels einer entsprechenden Auswertungsschaltung diese Widerstandsänderung erfasst werden kann.

Ausgehend von diesem grundsätzlichen Prinzip einer Schaltmatte bietet eine zweikanalige Schaltmatte den Vorteil, dass bei Ausfall einer Elektrode, beispielsweise aufgrund eines Kabelbruchs o. dgl., eine redundante weitere Elektrodenanordnung vorgesehen ist, so dass durch die zweikanalige Ausgestaltung deren Funktionssicherheit verbessert ist. Ein wesentlicher Aspekt einer zweikanaligen Schaltmatte ist die Fehlererkennung: Es werden zwei Eingangssignale durch einen Controller erfasst. Kommt - beispielsweise aufgrund eines Kabelbruchs in einem der beiden Kanäle - nur ein Signal beim Controller an, schaltet dieser automatisch in den sicheren Zustand.

Üblicherweise werden derartige zweikanalige Schaltmatten dadurch geschaffen, dass die beiden Elektroden, die innerhalb einer Elektrodenlage angeordnet sind, ähnlich wie ineinander verschränkte Finger zweier Hände angeordnet sind. So können an zwei gegenüberliegenden Seiten einer rechteckigen Schaltmatte zwei Elektroden-Längsstreifen vorgesehen sein, von denen sich dann jeweils eine Vielzahl von Elektroden-Querstreifen in Richtung zum gegenüberliegenden Elektroden-Längsstreifen erstreckt, ohne jedoch diesen gegenüberliegenden Elektroden-Längsstreifen zu kontaktieren. Die Elektroden-Querstreifen sind zueinander versetzt angeordnet und voneinander beabstandet, so dass eine Kontaktierung beider Elektroden derselben Lage vermieden wird.

In vielen Anwendungsfällen ist es wünschenswert, der zu verwendenden Schaltmatte eine bestimmte Geometrie zu vermitteln. Beispielsweise kann um ein bewegliches Arbeitsgerät herum, beispielsweise um einen Roboterarm herum, eine kreissegmentförmige Gefahrenzone definiert sein, wobei mittels einer entsprechenden Schaltmatte überwacht wird, dass beim Betreten dieser Gefahrenzone das Arbeitsgerät abgeschaltet wird bzw. weitere Bewegungen dieses Arbeitsgerätes unterbunden werden. Für den Aufbau der oben erwähnten zweikanaligen Schaltmatten mit dem Verlauf der Elektroden die jeweils etwa einem Kamm ähnlich ausgestaltet sind, bedeutet dies einen erheblichen wirtschaftlichen Aufwand, um die Elektrodenform der jeweils gewünschten Geometrie der Schaltmatte anzupassen.

Aus der DE 633 460 A, die den nächstkommenden Stand der Technik bildet, ist ein elektrisches Musikinstrument mit vorbelasteten, belastungsempfindlichen Tasten bekannt, bei welchem mehrere jeweils mehrlagige Druckwiderstände vorgesehen sind. Bei einem Ausführungsbeispiel sind Druckkontakte zum Spielen des Musikinstruments vorgesehen, die als taktile Sensoren angesehen werden können. Im Ruhezustand wird ein Stromfluss durch eine erste, feststehend angeordnete und eine mittlere, bewegliche Elektrode ermöglicht. Bei Betätigung des Druckkontakts wird die mittlere Elektrode bewegt und so von der ersten Elektrode getrennt und einer dritten, ebenfalls feststehend angeordneten Elektrode angenähert. Dadurch wird ein Stromfluss durch die mittlere und eine dritte Elektrode ermöglicht, nämlich zu einem Verstärker. So wird ein Umschalter geschaffen, der es ermöglicht, einen Tongenerator akustisch vorteilhaft dauerhaft zu betreiben und dabei die dauernd erzeugten Tonimpulse in den Spielpausen abzuleiten, während sie bei Betätigung des Druckkontakts zum Verstärker geleitet und hörbar gemacht werden.

Aus der US 2002/0190727 A1 ist ein kapazitiver Sensor bekannt, der bei PC-basierten Anwendungen beispielsweise die Bewegungen eines Joysticks erfasst, und der wahlweise die Intensität einer Betätigungskraft erfasst oder als Schalter wirkt.
Aus der EP 0 684 579 A2 ist ein Sensor bekannt, der bei PC-basierten Anwendungen beispielsweise als Touchpad dazu dient, die Bewegungen eines Gegenstandes wie z. B. eines Fingers, eines Stiftes oder dergleichen zu digitalisieren und beispielsweise virtuelle Schaltelemente zu betätigen, die auf einem Bildschirm dargestellt werden.

Der Erfindung liegt die Aufgabe zugrunde, einen gattungsgemäßen Sensor dahingehend zu verbessern, dass dieser mit vergleichsweise geringem wirtschaftlichen Aufwand die Ausgestaltung von zweikanaligen Sensoren unterschiedlicher Geometrie ermöglicht.

Diese Aufgabe wird durch einen Sensor mit den Merkmalen des Anspruchs 1 gelöst.

Die Erfindung schlägt mit anderen Worten vor, den Sensor, beispielsweise eine Schaltmatte, nicht 3-lagig, sondern 5-lagig auszugestalten. Angesichts des angestrebten Zieles, den Aufbau der Schaltmatte möglichst wirtschaftlich zu ermöglichen, ist diese Verwendung zusätzlicher Lagen für die Herstellung der Schaltmatte überraschend, denn durch die vorschlagsgemäß vorgesehene zusätzliche Zwischenlage sowie zusätzliche Elektrodenlage scheint auf den ersten Blick der Aufbau der Schaltmatte aufwendiger oder komplizierter zu sein. Überraschend stellt sich jedoch heraus, dass durch die vorschlagsgemäße Ausgestaltung der Schaltmatte deren Herstellung besonders einfach und wirtschaftlich vorteilhaft erfolgen kann: Wenn beispielsweise die jeweiligen Elektroden als Flächengebilde ausgestaltet sind, beispielsweise als metallische Folien, elektrisch leitfähig ausgestaltete Polymerfolien, elektrisch leitfähig ausgestaltete Textilien oder dergleichen, ergibt sich eine überraschend einfache Herstellung der Schaltmatte in der gewünschten Geometrie dadurch, dass die Schaltmatte einfach entsprechend der gewünschten Geometrie zugeschnitten werden kann. Anders als bei den Schaltmatten, die mit kammartig verlaufenden Elektroden versehen sind, bedeutet der Beschnitt eines Randes bei dem 5-lagigen Aufbau der Schaltmatte nicht notwendigerweise eine Unterbrechung des elektrischen Kontakts zu bestimmten, funktionsrelevanten Bereichen der Schaltmatte, so dass aus diesem Grund beliebige Konturen der Schaltmatte verwirklicht werden können. Vorschlagsgemäß sind die Elektroden nämlich untereinander angeordnet und nicht nebeneinander wie die erwähnten kammartigen Elektroden.

Zur Anpassung an eine vorgegebene Geometrie ist also vorschlagsgemäß nicht eine besondere, auf den Einzelfall abgestimmte Ausgestaltung der Elektroden erforderlich, so dass in überraschender Weise trotz des Aufbaus mit mehr als den herkömmlich verwendeten Lagen die Schaltmatte besonders wirtschaftlich hergestellt werden kann.

Im Unterschied zu anderen zweikanaligen Ausgestaltungen, bei denen zwei Paare von Elektroden vorgesehen sind, also insgesamt vier Elektroden, und die zum Anschluss an eine Steuerung dementsprechend Kabel mit vier Adern erfordern, kann der vorschlagsgemäße Sensor mit nur drei Elektroden und dementsprechend einer nur dreiadrigen Verkabelung betrieben werden. Im Vergleich zu einer zweikanaligen Ausgestaltung eines Sensors, bei der die einzelnenn Elektroden übereinander angeordnet sind, wird durch die Verwendung von nur drei statt vier Elektroden sowohl Material als auch Bauhöhe des Sensors eingespart.

Dadurch, dass insgesamt drei Elektrodenlagen vorgesehen sind, erfolgt bei einem Druck auf die Schaltmatte nicht nur eine Signalisierung zwischen der oberen und der mittleren Elektrode, sondern auch eine Signalisierung zwischen der unteren und der mittleren Elektrode, so dass die gewünschte zweikanalige Ausgestaltung der Schaltmatte gegeben ist. Gegebenenfalls kann mittels eines entsprechenden Controllers, also einer Auswertungselektronik, die zur Auswertung von drei Signalkanälen ausgestaltet ist, sogar eine dreikanalige Ausgestaltung des Sensors verwirklicht werden, wenn sich beispielsweise unterschiedliche Spannungs- bzw. Widerstandswerte zwischen folgenden Elektrodenpaaren ergeben: erstens zwischen der oberen und der mittleren Elektrode, zweitens zwischen der unteren und der mittleren Elektrode, und drittens zwischen den beiden äußeren Elektroden.

Vorschlagsgemäß wird eine Zwischenschicht verwendet, die nicht elektrisch leitend, sondern isolierend ist und zudem derart ausgelegt ist, dass sich die Elektroden bei Kraftbeaufschlagung berühren, so dass eine Signalerzeugung in Art eines Schließerkontaktes erfolgt. Eine solch isolierende Zwischenschicht kann beispielsweise einzelne, voneinander beabstandete Streifen oder Plättchen enthalten, die z. B. aus einem Elastomermaterial, einem Schaumwerkstoff, Filz oder dergleichen bestehen können und als Abstandshalter für die Elektroden dienen. Auch Luft oder ein anderes Gas, welches sich innerhalb der Zwischenschicht zwischen derartigen Elementen befindet, stellt einen elektrischen Isolator dar. Bei Druck auf die Schaltmatte werden die beiderseits der Zwischenschicht befindlichen Elektroden verformt und die Zwischenschicht komprimiert, so dass die Elektroden in unmittelbaren Kontakt miteinander gelangen.

Vorteilhaft kann eine Zwischenschicht aus dem bereits weiter oben erwähnten Material bestehen, welches unter Druck seinen elektrischen Widerstand, der zwischen den beiden angrenzenden Elektroden herrscht, verringert, also seine elektrische Leitfähigkeit vergrößert. Durch die Verwendung derartiger Materialien können besonders flache Zwischenschichten verwirklicht werden, so dass trotz des 5-lagigen Aufbaus der Schaltmatte die Schaltmatte insgesamt nicht nachteilig dick wird und beispielsweise auf dem Boden liegend eine Stolperkante darstellt.

Vorteilhaft kann über die Zweikanaligkeit hinaus die Schaltmatte eine weitere Funktion ermöglichen, nämlich eine Ortsauflösung, so dass der Ort bestimmt werden kann, an welchem der Druck auf die Schaltmatte ausgeübt wurde. Auf diese Weise lässt sich bei Verwendung einer einzigen Schaltmatte ein zu überwachender Bereich in mehrere Zonen aufteilen. Bei dem weiter oben erwähnten Beispiel eines Sicherheitsbereiches um eine Arbeitsmaschine herum kann beispielsweise eine äußere Sicherheitszone geschaffen werden, bei deren Betreten die Maschinensteuerung die Arbeitsmaschine beispielsweise in einen langsameren Bewegungsmodus schaltet. Wird ein Druck auf die Schaltmatte noch näher an der Arbeitsmaschine registriert, nämlich in einem inneren Sicherheitsbereich, so kann mittels der Anlagensteuerung die Arbeitsmaschine beispielsweise vollständig in einen Stillstand geschaltet werden, um hier die maximale Sicherheit für Personal zu gewährleisten, welches sich auf der Schaltmatte befindet.

Um die erwähnte Ortsauflösung der Schaltmatte zweikanalig zu ermöglichen, kann vorteilhaft in jeder der drei Elektrodenlagen die Anordnung von zwei oder mehr Elektroden vorgesehen sein, wobei diese beiden Elektroden jeweils mittels einer eigenen Signalleitung mit dem Controller verbunden sind. Die innerhalb derselben Lage angeordneten Elektroden sind voneinander beabstandet, so dass sich die beiden Elektroden innerhalb derselben Lage nicht kontaktieren können. Hierzu können die Elektroden beispielsweise als längliche Streifen ausgestaltet sein, wobei die Streifen in zwei übereinander angeordneten Elektrodenlagen in unterschiedlichen Richtungen verlaufen, so dass sich, von oben gesehen, Kreuzungspunkte ergeben. Jeder Kreuzungspunkt von zwei Elektroden, die übereinander in zwei unterschiedlichen Lagen angeordnet sind, bildet einen Ort, welcher separat ausgewertet werden kann.

Vorteilhaft kann vorgesehen sein, dass eine Elektroden-Lage als textiles Flächengebilde ausgestaltet ist. Statt einer vollflächig ausgestalteten Elektrode, beispielsweise einer elektrisch leitenden Folie, einer Oberflächenbeschichtung o. dgl. ist dabei vorgesehen, dass die Elektrode in dieser textilen Lage durch wenigstens einen elektrisch leitenden Faden gebildet ist. Beispielsweise kann ein solcher Faden mäanderförmig oder serpentinenförmig verlaufen, so dass praktisch die gesamte Fläche dieses textilen Flächengebildes für den vorgesehenen Anwendungsfall als Sensorfläche wirksam genutzt werden kann, obwohl wirtschaftlich vorteilhaft nur ein Bruchteil dieser Fläche tatsächlich den z. B. metallischen Elektrodenwerkstoff aufweist.

Vorteilhaft kann bei einem solch textilen Flächengebilde vorgesehen sein, dass die Elektrode nicht einen einzigen elektrisch leitfähigen Faden aufweist, sondern mehrere beabstandet zueinander verlaufende Fäden, wodurch die Herstellung dieses textilen Flächengebildes besonders unkompliziert und dementsprechend wirtschaftlich möglich ist. Beispielsweise können mehrere parallel verlaufende derartige Fäden jeweils einzeln mit einem Controller verbunden werden, so dass sie wie weiter oben erwähnt für eine Ortsauflösung innerhalb der Schaltmatte genutzt werden können. Oder derartige parallele Fäden können durch elektrisch leitende Querfäden miteinander verbunden werden, so dass sämtliche Fäden innerhalb einer Elektroden-Lage eine einzige, über die gesamte Fläche wirksame Elektrode bilden.

Vorteilhaft kann bei der Verwendung eines textilen Flächengebildes als Elektrode vorgesehen sein, dass oberhalb dieser Elektroden-Lage eine Druckverteilungslage angeordnet ist. Auf diese können beispielsweise die mehreren verwendeten Fäden einen vergleichsweise großen Abstand zueinander aufweisen, oder ein serpentinenförmig verlaufender Faden kann zwischen seinen einzelnen benachbarten Abschnitten einen vergleichsweise großen Abstand aufweisen, so dass im Ergebnis die Herstellung des textilen Flächengebildes wirtschaftlich vorteilhaft beeinflusst wird. Die gewünschte Schaltempfindlichkeit der Schaltmatte wird durch die Druckverteilungslage sichergestellt, so dass beispielsweise auf eine sehr kleine Fläche auftreffende Punktlasten auf eine insgesamt größere Fläche verteilt werden, so dass der dort herrschende Druck zu dem gewünschten Schaltsignal führt.

Das textile Flächengebilde kann vorteilhaft als gewebtes Textil ausgestaltet sein, so dass eine besonders flache Ausgestaltung der Elektrodenlage und damit auch insgesamt der Schaltmatte ermöglicht wird. Bei diesem Webtextil können die elektrisch leitfähigen Fäden sowohl im Schuss als auch in der Kette vorgesehen sein, so dass ein Rechteckmuster oder quadratisches Muster an leitfähigen Fäden innerhalb dieses Webtextils geschaffen wird. Durch die Kreuzungspunkte der Schuss- und Kettfäden stehen sämtlich Abschnitte der leitfähigen Fäden miteinander in Verbindung, so dass eine über die gesamte Fläche des textilen Flächengebildes hinweg wirksame Elektrode gebildet wird. Die Funktionsfähigkeit der Elektrode ist auch dann sichergestellt, wenn dieses textile Flächengebilde am Rand beschnitten wird oder aus der Mitte des textilen Flächengebildes ein Loch ausgeschnitten wird, so dass auf diese Weise die Schaltmatte sehr vielseitig an die unterschiedlichsten gewünschten Geometrien angepasst und in solchen Geometrien hergestellt werden kann.

Vorteilhaft kann die vorschlagsgemäß ausgestaltete Schaltmatte nicht als eine einzige, sozusagen monolithische Schaltmatte ausgestaltet sein, die den gesamten zu überwachenden Bereich abdeckt. Vielmehr kann eine vorschlagsgemäß ausgestaltete Schaltmatte als eine so genannte Kachel ausgestaltet sein, die zusammen mit anderen, gleichartigen Kacheln die insgesamt größere Schaltmatte bildet, die in diesem Fall als so genannte Verbundschaltmatte bezeichnet ist. Um diese Verbindung mit anderen Kacheln zu ermöglichen, ist jede einzelne Elektrode einer Kachel mit jeweils zwei Verbindungselementen versehen bzw. an solche Verbindungselemente elektrisch leitend angekoppelt. Die beiden Verbindungselemente sind komplementär zueinander ausgestaltet, betreffen also beispielsweise einen Typ A und einen Typ B, wobei diese beiden unterschiedlichen Typen miteinander verbunden werden können.

Auf diese Weise können zwei benachbarte Kacheln derart angeordnet werden, dass die Verbindungselemente des Typs A der einen Kachel mit den Verbindungselementen des Typs B der benachbarten Kachel verbunden werden können, so dass auf diese Weise eine Reihenanordnung der Kacheln möglich ist. Die Ausgestaltung der Schaltmatte als eine solche Kachel ermöglicht die Ausgestaltung insgesamt größerer Verbundschaltmatten in nahezu beliebiger Größe und nahezu beliebiger Geometrie einfach dadurch, dass entsprechend viele Kacheln miteinander verbunden werden. Die Schaltmatten können als ein einziger, beispielsweise quadratischer Typ hergestellt und an Ort und Stelle bedarfsgerecht zusammengefügt werden. Es können jedoch auch unterschiedliche Grundtypen von Schaltmatten hergestellt werden, beispielsweise in unterschiedlichen Größen, oder mit unterschiedlichen Geometrien wie Quadrat, Trapez, Kreisausschnitt oder dergleichen, so dass mit wenigen Grundtypen eine optimal an eine vorgegebene Kontur angepasste Verbundschaltmatte konfektioniert werden kann.

Dabei kann vorteilhaft vorgesehen sein, dass die erwähnten Verbindungselemente als Steckverbinder ausgestaltet sind, so dass ohne die Verwendung von speziellen Instrumenten oder Geräten die Kacheln nicht nur werkseitig, sondern insbesondere auch an dem gewünschten Verlegeort zu der insgesamt größeren Verbundschaltmatte zusammengefügt werden können. Besonders vorteilhaft kann in einem solchen Fall vorgesehen sein, die Verbindungselemente als Druckknöpfe auszugestalten. Auf diese Weise erfolgt die Verbindung zweier komplementärer Verbindungselemente durch einen Druck in derselben Richtung, in der auch die Schaltmatte belastet wird, so dass die hergestellten Verbindungen im täglichen Betrieb beispielsweise beim Begehen einer Schaltmatte zuverlässig verbunden bleiben und nicht etwa versehentlich getrennt werden.

Die Druckknöpfe ermöglichen eine lösbare und einfach herstellbare sowie veränderbare Verbindung benachbarter Kacheln. Alternativ zu den erwähnten Druckknöpfen können die Verbindungselemente als Teile eines Häkchenverschlusses oder als flach bauende Steckverbinder ausgestaltet sein, oder es kann, falls keine lösbare Verbindung geschaffen werden soll, eine Verbindung benachbarter Kacheln durch Nähen oder Kleben erfolgen.

Bei der Ausgestaltung einer Schaltmatte als Kachel kann vorteilhaft vorgesehen sein, dass von den beiden Verbindungselementen einer Elektrode ein Verbindungselement an einer Lasche vorgesehen ist, die sich über die Abmessungen der übrigen Kachel, also über die übrige Umfangskontur dieser Kachel hinaus erstreckt. Auf diese Weise können zwei benachbarte Kacheln lückenlos aneinander gelegt werden und in wirtschaftlich vorteilhafter Weise müssen sich die beiden benachbarten Kacheln nicht großflächig überlappen, um die gewünschte Verbindung der benachbarten Verbindungselemente zu ermöglichen, sondern hierzu ragen lediglich die erwähnten Laschen der Verbindungselemente über die benachbarte Kachel, um mit den dort vorgesehenen komplementären Verbindungselementen zusammenzuwirken.

Die weiter oben angesprochene Ortsauflösung betrifft eine Ausgestaltung der Schaltmatte, bei welcher eine Ortsauflösung innerhalb der Schaltmatte selbst ermöglicht ist. Eine andere Verwirklichung der Ortsauflösung kann vorgesehen sein, wenn die bereits erwähnte, insgesamt größere und als Verbundschaltmatte bezeichnete Schaltmatte aus vielen kleineren, als Kacheln bezeichneten Schaltmatten zusammengesetzt ist. In diesem Fall muss nicht notwendigerweise eine Ortsauflösung innerhalb jeder einzelnen Kachel möglich sein. Vielmehr kann die Ortsauflösung innerhalb der Verbundschaltmatte durch die Unterscheidung ermöglicht werden, in welcher Kachel das Signal erzeugt wird, so dass die Größe der Kacheln die Auflösungsgenauigkeit der Ortsauflösung bestimmt.

Ausführungsbeispiele erfindungsgemäßer Sensoren werden anhand der rein schematischen Darstellungen nachfolgend näher erläutert. Dabei zeigt
- Fig. 1: schematisch einen Aufbau durch die schaltwirksamen Lagen einer vorschlagsgemäßen Schaltmatte,
- Fig. 2: eine perspektivische Ansicht auf ein zweites Ausführungsbeispiel in auseinander gezogener Darstellung,
- Fig. 3: in ebenfalls auseinander gezogener, perspektivischer Darstellung eine Ansicht auf die schaltwirksamen Lagen einer als Kachel ausgestalteten Schaltmatte, und
- Fig. 4: eine Ansicht auf einen aus mehreren Kacheln gebildeten Verbund.

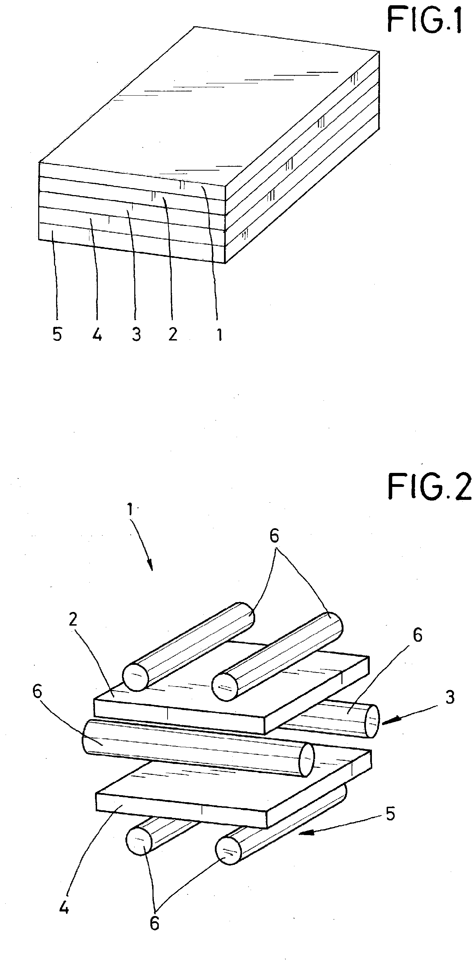

In Fig. 1 ist ein Ausschnitt aus einem taktilen Sensor in Form einer Schaltmatte dargestellt, wobei elektrische Leitungen sowie obere und untere Deckschichten einer solchen Schaltmatte, sowie eine ggf. vorgesehene Druckverteilungslage, nicht dargestellt sind. Vielmehr zeigt Fig. 1 lediglich die schaltwirksamen Lagen einer Schaltmatte, wobei insgesamt fünf Lagen übereinander angeordnet sind, die von oben nach unten von 1 - 5 durchnummeriert sind. Die erste, obere Lage 1 wird durch eine so genannte obere Elektrode gebildet, die beispielsweise aus einem elektrisch leitfähigen Kunststoff bestehen kann, beispielsweise in Form einer Kunststofffolie, oder die durch eine metallische Folie gebildet sein kann, oder durch eine metallisierte Kunststofffolie, wobei vorteilhaft vorgesehen sein kann, diese obere, erste Lage 1 als textiles Flächengebilde auszugestalten, welches dadurch zu einer Elektrode wird, dass ein einzelner elektrisch leitfähiger Faden serpentinenförmig oder mäanderförmig vorgesehen ist oder dass mehrere, sich kreuzende elektrisch leitfähige Fäden in diesem textilen Flächengebilde vorgesehen sind.

Mittels einer zweiten Lage 2, die als Zwischenschicht ausgestaltet ist, ist die obere Lage 1 vollflächig von einer mittleren Lage 3 getrennt, die als so genannte mittlere Elektrode ausgestaltet ist. Die Zwischenschicht 2 weist einen elektrischen Widerstand auf, der sich bei Druck ändert, so dass unter Druck der messbare elektrische Widerstand zwischen der oberen Elektroden-Lage 1 und der mittleren Elektroden-Lage 3 verringert wird, was mittels eines entsprechenden Controllers ausgewertet werden kann. Alternativ dazu kann die Zwischenschicht 2 auch als elektrisch isolierende Schicht ausgestaltet sein, die nicht vollflächig die beiden Lagen 1 und 3 trennt. In diesem Fall wird ein Schließersystem aufgebaut und die Elektroden-Lagen 1 und 3 berühren sich bei Druck.

Unterhalb der mittleren Elektroden-Lage 3 ist eine weitere Zwischenschicht 4 als vierte Lage vorgesehen, durch welche die zweite Elektroden-Lage 3 von einer dritten, unteren ElektrodenLage 5 beabstandet ist. Bei einem Druck quer auf die Fläche dieser fünf Lagen 1 - 5 erfolgt eine Widerstandsänderung sowohl zwischen der ersten und der zweiten Elektroden-Lage 1 und 3 als auch zwischen der zweiten und dritten Elektroden-Lage 3 und 5, so dass hierdurch ein zweikanaliger Aufbau der Schaltmatte bewirkt ist.

Fig. 2 zeigt einen ebenfalls fünflagigen Aufbau der schaltwirksamen Lagen einer Schaltmatte, wobei im Unterschied zu Fig. 1 zwar ebenfalls vollflächig wirksame Elektroden in den Elektroden-Lagen 1, 3 und 5 vorgesehen sind, jedoch sind bei diesem Ausführungsbeispiel die Elektroden durch einzelne so genannte Adern 6 gebildet, beispielsweise durch auf eine Trägerfläche aufgedruckte Streifen aus elektrisch leitfähigem Material, oder durch auf eine Trägerfläche aufgebrachte Kabel bzw. Litzen, oder durch elektrisch leitfähige Fasern als Teil eines textilen Flächenelements. Die erwähnte Trägerfläche kann durch eine in Fig. 2 nicht dargestellte Schicht gebildet sein, jedoch kann auch eine Zwischenschicht 2 bzw. 4 ein solches Trägermaterial darstellen, das dann ein- oder beidseitig mit den Adern 6 versehen sein kann und einen besonders flachen Aufbau der Schaltmatte ermöglicht.

Durch die Verwendung zweier unterschiedlicher Adern 6 in jeder Elektroden-Lage 1, 3 und 5 kann in an sich bekannter Weise eine Ortsauflösung ermöglicht werden, indem die dargestellten Adern 6 parallel zueinander verlaufende und separat an einen Controller angeschlossene Elektrodenstreifen bilden.

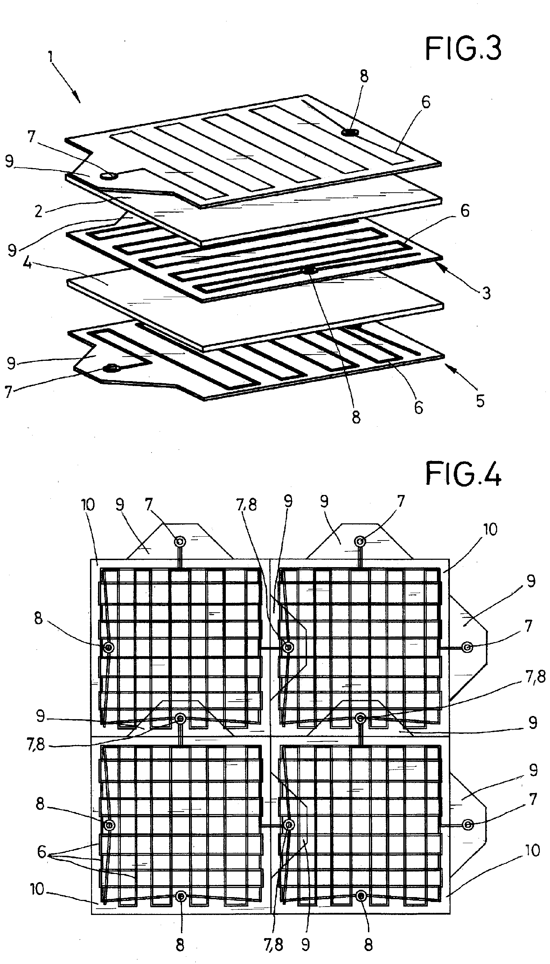

Während die Fig. 1 und 2 Ausschnitte aus einer Schaltmatte mit insgesamt größerer Fläche darstellen, ist in Fig. 3 die Anordnung der fünf schaltwirksamen Lagen 1 - 5 einer Schaltmatte dargestellt, wobei diese einzelnen Lagen 1 - 5 jeweils in ihrer vollständigen Ausdehnung dargestellt sind. Die erste Lage ist als Elektrode ausgestaltet, indem eine elektrisch leitfähige Ader 6 serpentinenförmig über nahezu die gesamte Abmessung dieser ersten Lage 1 verläuft. An zwei gegenüberliegenden Enden dieser Elektroden-Lage 1 ist die Ader 6 an zwei unterschiedliche und komplementär ausgestaltete Verbindungselemente 7 und 8 angekoppelt, welche als Steckverbinder, nämlich als Druckknopf ausgestaltet sind, wobei das Verbindungselement 7 als Stecker und das Verbindungselement 8 als Buchse eines solchen Druckknopfverschlusses ausgestaltet ist. Das Verbindungselement 7 ist dabei an einer Lasche 9 vorgesehen, welche sich über die ansonsten rechteckige Umfangskontur der ersten Elektroden-Lage 1 hinaus erstreckt.

Die zweite Elektroden-Lage 3 ist derart angeordnet, dass sich deren Lasche 9 in einer rechtwinkligen Ausrichtung zur Lasche 9 der ersten Elektroden-Lage 1 erstreckt.

Die grundsätzlich rechteckige Kontur der fünf Lagen 1 - 5 bei dem Ausführungsbeispiel der Fig. 3 kann insbesondere quadratisch gewählt sein, denn die dargestellte Schaltmatte kann als eine von mehreren so genannten Kacheln dazu dienen, zusammen mit den anderen, gleichartigen Kacheln eine insgesamt größere Verbundschaltmatte zu bilden, so dass das Ausführungsbeispiel der Fig. 3 insbesondere dazu dient, mit Hilfe standardisierter Elemente nahezu beliebig konturierte Verbundschaltmatten zu erzeugen. Im Sinne dieser Standardisierung und der Reduzierung auf möglichst wenige unterschiedliche Bauelemente ermöglicht eine quadratische Ausgestaltung der Zwischenlagen 2 und 4 sowie der Elektroden-Lagen 1, 3 und 5 die Verwendung von nur zwei unterschiedlichen Bauteiltypen bei den fünf dargestellten Lagen 1, 2, 3, 4 und 5: Die Elektroden-Lagen 1, 3 und 5 können durch die Verwendung des gleichen Elektrodentyps mit nur unterschiedlicher Ausrichtung, je nach Ausrichtung der Laschen 9, erzeugt werden und die beiden Zwischenlagen 2 und 4 sind ebenfalls identisch ausgestaltet.

Fig. 4 zeigt die Anordnung von vier nach Fig. 3 ausgestalteten Kacheln 10, wie dies zur Schaffung einer größeren Verbundschaltmatte vorgesehen ist.

Bei der Kachel oben links ist ein oberes Verbindungselement 8 mit der leitfähigen Ader 6 der oberen Elektroden-Lage 1 verbunden, deren Abschnitte großteils senkrecht verlaufend dargestellt sind und durch kurze, horizontal verlaufende Abschnitte miteinander verbunden sind. Diese Ader 6 verläuft bis zu dem gegenüberliegenden Verbindungselement 7, welches in der Lasche 9 am rechten Rand dieser oberen Lage angeordnet ist. Mit diesem oberen Verbindungselement 7 der Kachel oben links ist ein oberes Verbindungselement 8 der Kachel oben rechts verbunden, und die sich daran anschließende Ader 6 ist in der gleichen Weise, wie für die Kachel 10 oben links beschrieben, bis zu dem gegenüberliegenden Verbindungselement in der Lasche 9 am rechten Rand dieser oberen Lage der rechten oberen Kachel 10 geführt.

Auf diese Weise wird in der oberen Elektroden-Lage 1 eine durchgängige obere Elektrode in Art eines horizontal verlaufenden Streifens geschaffen, der sich über die beiden nebeneinander liegenden, in Fig. 4 oben dargestellten Kacheln 10 erstreckt. In gleicher Weise ergibt sich für die in der Zeichnung darunter dargestellten Kacheln 10 unten links und unten rechts ebenfalls in der oberen Elektroden-Lage 1 eine durchgängige obere Elektrode in Art eines in der Zeichnung horizontal verlaufenden Streifens. Diese beiden Streifen sind voneinander getrennt und separat mit einem Controller verbunden.

Für die mittleren Elektroden-Lagen 3 der vier dargestellten Kacheln 10 gilt der grundsätzlich gleiche Aufbau, jedoch um 90° versetzt, so dass zwei streifenförmige, in der Zeichnung senkrecht verlaufende Elektroden geschaffen werden, von denen die linke durch die Kacheln 10 oben links und unten links verläuft, und die rechte durch die Kacheln 10 oben rechts und unten rechts.

Die Adern 6 und deren Verbindungselemente 7 und 8 in den unteren Elektroden-Lagen 5 sind wiederum um 90° zu den mittleren Elektroden-Lagen 3 versetzt und deckungsgleich mit den oberen Adern 6 angeordnet, so dass sie in der Darstellung der Fig. 4 nicht eigens ersichtlich sind.

Wenn jeder der sich über mehrere Kacheln 10 erstreckenden Elektrodenstreifen einzeln an einen Controller angeschlossen ist, so stellt jede Kachel 10 einen Kreuzungspunkt dar, an welchem sich die oberen und unteren mit den mittleren derartigen Elektrodenstreifen kreuzen. Dementsprechend kann, wenn eine Kachel 10 mit Druck beaufschlagt wird, automatisch ausgewertet werden welcher der in Fig. 4 horizontal und welcher der vertikal verlaufenden Elektrodenstreifen an der Signalisierung beteiligt ist, so dass dementsprechend eine zweikanalige Ortsauflösung mit der Auflösungsgenauigkeit einer Kachel 10 erreicht wird.

## Patentansprüche

1. Mehrlagiger taktiler Sensor,
mit einer ersten Elektrode in einer ersten Lage (1) des Sensors,
einer drucksensitiven Zwischenschicht, welche eine zweite Lage (2) des Sensors bildet,
und einer zweiten Elektrode in einer dritten Lage (3) des Sensors
wobei die zweite Elektrode der dritten Lage (3) von der ersten Elektrode der ersten Lage (1) durch die Lage (2) der Zwischenschicht beabstandet ist,
wobei der Sensor zusätzlich zu den beschriebenen drei Lagen (1, 2, 3) zwei weitere Lagen (4, 5) aufweist, wobei eine zweite drucksensitive Zwischenschicht eine vierte Lage (4) des Sensors bildet,
eine dritte Elektrode vorgesehen ist, welche eine fünfte Lage (5) des Sensors bildet und mittels der Lage (4) der zweiten drucksensitiven Zwischenschicht von der dritten Lage (3) der zweiten Elektrode beabstandet ist,
und wenigstens eine der drucksensitiven Zwischenschicht-Lagen (2, 4) aus einem elektrisch isolierenden Material besteht,
**dadurch gekennzeichnet,**
**dass** der Sensor insgesamt fünf schaltwirksame Lagen (1, 2, 3, 4, 5) aufweist,
mit insgesamt drei Elektrodenlagen,
und **dass** der Sensor zweikanalig als Schließer ausgestaltet ist, derart, dass bei einem Druck auf die Schaltmatte nicht nur eine Signalisierung zwischen der oberen und der mittleren Elektrode erfolgt, sondern auch eine Signalisierung zwischen der unteren und der mittleren Elektrode.

2. Sensor nach Anspruch 1,
**dadurch gekennzeichnet,**
**dass** wenigstens eine der drucksensitiven Zwischenschicht-Lagen (2, 4) aus einem Material besteht, welches unter Druck seinen zwischen den beiden angrenzenden Elektroden-Lagen (1, 3, 5) wirksamen elektrischen Widerstand verringert.

3. Sensor nach Anspruch 1 oder 2,
**dadurch gekennzeichnet,**
**dass** in jeder der drei Lagen (1, 3, 5), in welcher Elektroden vorgesehen sind, jeweils wenigstens zwei Elektroden vorgesehen sind,
die jeweils mehrere Abschnitte aufweisen,
wobei die Abschnitte der einen Elektrode versetzt zu den Abschnitten der anderen Elektrode in derselben Lage (1, 3, 5) verlaufen.

4. Sensor nach einem der vorhergehenden Ansprüche, **dadurch gekennzeichnet,**
**dass** eine Elektroden-Lage (1, 3, 5) vorgesehen ist, die als textiles Flächengebilde ausgestaltet ist,
wobei eine Elektrode in dieser Lage (1, 3, 5) durch wenigstens einen elektrisch leitenden Faden gebildet ist.

5. Sensor nach Anspruch 4,
**dadurch gekennzeichnet,**
**dass** die Elektrode durch mehrere beabstandet zueinander verlaufende und elektrisch miteinander verbundene Fäden gebildet ist.

6. Sensor nach Anspruch 4 oder 5,
**dadurch gekennzeichnet,**
**dass** oberhalb der Lage (1, 3, 5), welche eine einen Faden aufweisende Elektrode enthält, eine Druckverteilungslage angeordnet ist.

7. Sensor nach einem der Ansprüche 4 bis 6,
**dadurch gekennzeichnet,**
**dass** das textile Flächengebilde gewebt ist, wobei die Elektrode elektrisch leitende Schuss- und Kettfäden aufweist.

8. Sensor nach einem der vorhergehenden Ansprüche, **dadurch gekennzeichnet,**
**dass** der Sensor als so genannte Kachel (10) ausgestaltet ist,
wobei die Kachel (10) mit anderen, gleichartigen Kacheln (10) zu einem insgesamt größeren Verbundsensor verbindbar ist,
und die einzelnen Elektroden der Kachel (10) jeweils elektrisch leitend an zwei Verbindungselemente (7, 8) angekoppelt sind,
wobei die beiden Verbindungselemente (7, 8) derselben Lage (1, 3, 5) komplementär miteinander zusammenwirkend ausgestaltet sind,
derart, dass die Elektroden zweier benachbarter Kacheln (10) wirksam miteinander verbindbar sind, indem die Verbindungselemente (7, 8) von Elektroden gleicher Lagen (1, 3, 5) miteinander verbunden werden und so der größere Verbundsensor gebildet wird.

9. Sensor nach Anspruch 8,
**dadurch gekennzeichnet,**
**dass** die Verbindungselemente (7, 8) als Steckverbinder ausgestaltet sind, wobei jede Elektrode an einen als Stecker ausgestalteten und einen als Buchse ausgestalteten Steckverbinder angekoppelt ist.

10. Sensor nach Anspruch 9,
**dadurch gekennzeichnet,**
**dass** die Verbindungselemente (7, 8) als Druckknöpfe ausgestaltet sind.

11. Sensor nach einem der Ansprüche 8 bis 10,
**dadurch gekennzeichnet,**
**dass** von den beiden derselben Elektrode zugeordneten Verbindungselementen (7, 8) eines an einer Lasche (9) vorgesehen ist, welche über die übrige Umfangskontur der Kachel (10) hinausragt.

12. Sensor nach einem der vorhergehenden Ansprüche, **dadurch gekennzeichnet,**
**dass** der Sensor mehrere voneinander getrennte Elektroden in jeder Elektroden-Lage (1, 3, 5) aufweist, wobei die Elektroden innerhalb einer Lage (1, 3, 5) voneinander getrennt sind
und die Elektroden in zwei benachbarten, untereinander angeordneten Lagen (1, 3, 5), sich kreuzend verlaufen.

## Claims

1. Multilayer tactile sensor
having a first electrode in a first layer (1) of the sensor and
having a pressure-sensitive interlayer forming a second layer (2) of the sensor and having a second electrode in a third layer (3) of the sensor,
where the second electrode of the third layer (3) is separated from the first electrode of the first layer (1) by the layer (2) of the interlayer,
where the sensor incorporates two further layers (4, 5) in addition to the aforedescribed three layers (1, 2, 3),
where a second pressure-sensitive interlayer forms a fourth layer (4) of the sensor and a third electrode is provided for that forms a fifth layer (5) of the sensor and is separated from the third layer (3) of the second electrode by means of the layer (4) of the second pressure-sensitive interlayer,
and that at least one of the pressure-sensitive interlayer layers (2, 4) is made of an electrically insulating material,
**characterised in that** the sensor incorporates altogether five switch-effective layers (1, 2, 3, 4, 5),
with altogether three electrode layers,
and that the sensor is designed as a normally-open switch having two channels such that, when pressure is applied to the switch mat, a signal is sent not only between the upper and the middle electrode but also between the lower and the middle electrode.

2. Sensor in accordance with claim 1, **characterised in that** at least one of the pressure-sensitive interlayer layers (2, 4) is made of a material that under pressure reduces its electrical resistance that is effective between the two adjacent electrode layers (1, 3, 5).

3. Sensor in accordance with claim 1 or 2, **characterised in that** in each of the three layers (1, 3, 5) in which electrodes are provided for at least two electrodes are provided for each of which incorporates a number of sections, where the sections of the one electrode are offset from the sections of the other electrode in the same layer (1, 3, 5).

4. Sensor in accordance with any one of the foregoing claims, **characterised in that** an electrode layer (1, 3, 5) is provided for that is designed as a flat textile element, where an electrode in this layer (1, 3, 5) is formed by at least one electrically conductive thread.

5. Sensor in accordance with claim 4, **characterised in that** the electrode is formed by a number of threads separated from and connected electrically to one another.

6. Sensor in accordance with claim 4 or 5, **characterised in that** a pressure distributing layer is arranged above the layer (1, 3, 5) that incorporates an electrode that incorporates a thread.

7. Sensor in accordance with any one of claims 4 to 6, **characterised in that** the flat textile element is woven, where the electrode incorporates electrically conductive weft and warp threads.

8. Sensor in accordance with any one of the foregoing claims, **characterised in that** the sensor is designed as a so-called tile (10),
where the tile (10) can be joined to other tiles (10) of the same kind to form an altogether larger compound sensor,
and each of the individual electrodes of the tile (10) are electrically conductively coupled to two joining elements (7, 8),
where the two joining elements (7, 8) of the same layer (1, 3, 5) are designed to coact complementarily,
such that the electrodes of two adjacent tiles (10) can be effectively connected to each other by connecting the joining elements (7, 8) of electrodes of like layers (1, 3, 5) together, so forming the larger compound sensor.

9. Sensor in accordance with claim 8, **characterised in that** the joining elements (7, 8) are designed as plug-type connectors, where each electrode is coupled to a plug-type connector designed as a plug and a plug-type connector designed as a plug socket.

10. Sensor in accordance with claim 9, **characterised in that** the joining elements (7, 8) are designed as push-buttons.

11. Sensor in accordance with any one of claims 8 to 10, **characterised in that** of the two joining elements (7, 8) assigned to the like electrode one is arranged on a portion (9) that projects from the remaining perimeter line of the tile (10).

12. Sensor in accordance with any one of the foregoing claims, **characterised in that** the sensor incorporates in each electrode layer (1, 3, 5) a number of electrodes that are separated from one another, where the electrodes within a layer (1, 3, 5) are separated from one another and the electrodes in two adjacent layers (1, 3, 5) arranged one below the other extend so as to cross over one other.

## Revendications

1. Capteur tactile multicouches
comprenant une première électrode dans une première couche (1) du capteur,
une strate intercalaire sensible à la pression et formant une deuxième couche (2) du capteur, et
une deuxième électrode dans une troisième couche (3) du capteur,
sachant que la deuxième électrode de la troisième couche (3) est maintenue à distance de la première électrode de la première couche (1) par la couche (2) de la strate intercalaire,
sachant que le capteur présente, en plus des trois couches (1, 2, 3) décrites, deux couches supplémentaires (4, 5).
sachant qu'une deuxième strate intercalaire sensible à la pression forme une quatrième couche (4) du capteur,
qu'une troisième électrode est prévue pour former une cinquième couche (5) du capteur et qui au moyen de la couche (4) de la deuxième strate intercalaire sensible à la pression est maintenue à distance de la troisième couche (3) de la deuxième électrode,
et qu'au moins l'une des couches (2, 4) de strates intercalaires sensibles à la pression se compose d'un matériau électriquement isolant,
**caractérisé en ce que** le capteur présente au total cinq couches (1, 2, 3, 4, 5) capables d'opérer une commutation,
avec total trois couches d'électrodes,
et **en ce que** le capteur est configuré sur deux canaux comme contact de travail, de sorte que lorsqu'une pression s'exerce sur le tapis de commutation, non seulement un signal est émis entre l'électrode du haut et celle du milieu, mais aussi un signal est émis entre l'électrode du bas et celle du milieu.

2. Capteur selon la revendication 1, **caractérisé en ce qu'au** moins l'une des couches (2, 4) de strates intercalaires sensibles à la pression est en un matériau dont la résistance électrique effective diminue, sous l'action de la pression, entre les deux couches (1, 3, 5) d'électrodes limitrophes.

3. Capteur selon la revendication 1 ou 2, **caractérisé en ce que** dans chacune des trois couches (1, 3, 5) dans lesquelles des électrodes sont prévues, respectivement au moins deux électrodes sont prévues
qui présentent chacune plusieurs segments,
sachant que les segments d'une électrode ont un tracé décalé par rapport aux segments de l'autre électrode dans la même couche (1, 3, 5).

4. Capteur selon l'une des revendications précédentes, **caractérisé en ce qu**'est prévue une couche (1, 3, 5) d'électrodes configurée en surface textile, sachant qu'une électrode dans cette couche (1, 3, 5) est formée par au moins un fil électroconducteur.

5. Capteur selon la revendication 4, **caractérisé en ce que** l'électrode est formée par plusieurs fils positionnés distants les uns des autres et électriquement reliés entre eux.

6. Capteur selon la revendication 4 ou 5, **caractérisé en ce qu'**au-dessus de la couche (1, 3, 5) qui contient une électrode présentant un fil, une couche servant à répartir la pression est disposée.

7. Capteur selon l'une des revendications 4 à 6, **caractérisé en ce que** la surface textile est tissée, sachant que l'électrode présente des fils de trame et de chaîne électroconducteurs.

8. Capteur selon l'une des revendications précédentes, **caractérisé en ce que** le capteur est configuré en tuile (10),
sachant que la tuile (10) est reliable avec d'autres tuiles (10) du même type pour former un capteur composite globalement de plus grande taille,
et que les différentes électrodes de la tuile (10) sont chacune reliées de manière électroconductrice à deux éléments de liaison (7,8),
sachant que les deux éléments de liaison (7, 8) de la même couche (1, 3, 5) sont configurés pour interagir ensemble de manière complémentaire,
de sorte que les électrodes de deux tuiles voisines (10) sont reliables l'une à l'autre de manière opérante en connectant ensemble les éléments de liaison (7, 8) d'électrodes de mêmes couches (1, 3, 5) pour former ainsi le capteur composite de plus grande taille.

9. Capteur selon la revendication 8, **caractérisé en ce que** les éléments de liaison (7, 8) sont configurés en connecteurs enfichables, sachant que chaque électrode est raccordée à un connecteur enfichable en forme de fiche mâle et à un connecteur enfichable en forme de fiche femelle.

10. Capteur selon la revendication 9, **caractérisé en ce que** les éléments de liaison (7, 8) sont configurés en boutons-pression.

11. Capteur selon l'une des revendications 8 à 10, **caractérisé en ce que** des deux éléments de liaison (7, 8) attribués à la même électrode, l'un est prévu contre une patte (9) qui fait saillie au-dessus du contour périphérique restant de la tuile (10).

12. Capteur selon l'une des revendications précédentes, **caractérisé en ce que** le capteur présente dans chaque couche (1, 3, 5) d'électrodes plusieurs électrodes séparées les unes des autres,
sachant que les électrodes sont séparées les unes des autres dans une couche (1, 3, 5) et
que les électrodes ont des tracés se croisant dans deux couches (1, 3, 5) voisines superposées.
